# EUROPEAN PATENT APPLICATION

(11) **EP 4 333 084 A1**
(43) Date of publication of application: **06.03.2024**
(21) Application number: 22795416.1
(22) Date of filing: 25.03.2022
(51) Int. Cl.: H01L 31/10, G01T 1/24, H01L 27/144

(54) **LIGHT-RECEIVING ELEMENT, X-RAY IMAGING ELEMENT, AND ELECTRONIC DEVICE**

(30) Priority: 28.04.2021 JP 2021075731
(71) Applicant: Sony Semiconductor Solutions Corporation, Atsugi-shi, Kanagawa 243-0014 (JP); RIKEN, Wako-shi, Saitama 351-0198 (JP)
(72) Inventor: HATSUI, Takaki, Wako-shi, Saitama 351-0198 (JP); KAWAMURA, Takahiro, Atsugi-shi, Kanagawa 243-0014 (JP); TOJINBARA, Hiroki, Atsugi-shi, Kanagawa 243-0014 (JP); OTA, Kazunobu, Atsugi-shi, Kanagawa 243-0014 (JP); SHIRAKATA, Toru, Atsugi-shi, Kanagawa 243-0014 (JP); IWATA, Hikaru, Atsugi-shi, Kanagawa 243-0014 (JP); ANDO, Atsuhiro, Atsugi-shi, Kanagawa 243-0014 (JP)
(74) Representative: MFG Patentanwälte Meyer-Wildhagen Meggle-Freund Gerhard PartG mbB
(86) International application number: PCT/JP2022/014358
(87) International publication number: WO 2022/230499

(57) **Abstract**

A light-receiving element according to an embodiment of the present disclosure includes: a semiconductor substrate (11) including a photoelectric conversion region; a first first electrically-conductive region (13A) provided at an interface of a first surface of the semiconductor substrate (11) and coupled to a first electrode (16); a second first electrically-conductive region (13B) provided at the interface of the first surface and around the first first electrically-conductive region (13A) and coupled to a second electrode (17); a third first electrically-conductive region (13C) provided at the interface of the first surface and around the second first electrically-conductive region (13B) and being in an electrically floating state; and an electrically-conductive film (21) provided above the first surface at least between the first first electrically-conductive region (13A) and the second first electrically-conductive region (13B).

## Description

### Technical Field

The present disclosure relates to a light-receiving element suitable for X-ray photography for medical application or non-destructive examination, for example, and an X-ray imaging element and an electronic apparatus including the light-receiving element.

### Background Art

Solid-state imaging devices are used in various applications including, for example, an imaging device such as a digital still camera or a video camera, an electronic apparatus such as a mobile terminal apparatus having an imaging function, or an electromagnetic wave sensor that detects various wavelengths other than that of visible light. Examples of the solid-state imaging devices include an APS (Active Pixel Sensor) including an amplifying element for each pixel; a CMOS (complementary MOS) image sensor (CIS) has been widely used that reads signal charge accumulated in a photodiode, as a photoelectric conversion element, via a MOS (Metal Oxide Semiconductor) transistor.

As a sensor for scientific use that requires high sensitivity measurement, a light-receiving element (PIN photodiode) has been used that has a structure in which a photoelectric conversion region and a floating diffusion region (Floating Diffusion; FD) are integrated (see, e.g., PTL 1). Such a light-receiving element is easy to be manufactured from a simple structure. In addition, any potential difference can be applied to a p-n junction that forms a photoelectric conversion region. This makes it easy to increase the thickness of the photoelectric conversion region.

### Citation List

### Patent Literature

PTL 1: Japanese Unexamined Patent Application Publication No. H11-4012

### Summary of the Invention

Incidentally, a light-receiving element used in an X-ray imaging element is required to have improved resistance to fluctuations in a capacity and an electric field due to X-ray irradiation.

It is desirable to provide a light-receiving element, an X-ray imaging element, and an electronic apparatus which have high resistance to fluctuations in a capacity and an electric field due to X-ray irradiation.

A light-receiving element according to an embodiment of the present disclosure includes: a semiconductor substrate including a photoelectric conversion region; a first first electrically-conductive region provided at an interface of a first surface of the semiconductor substrate and coupled to a first electrode; a second first electrically-conductive region provided at the interface of the first surface and around the first first electrically-conductive region and coupled to a second electrode; a third first electrically-conductive region provided at the interface of the first surface and around the second first electrically-conductive region and being in an electrically floating state; and an electrically-conductive film provided above the first surface at least between the first first electrically-conductive region and the second first electrically-conductive region.

An X-ray imaging element according to an embodiment of the present disclosure includes a plurality of the light-receiving elements according to the embodiment of the present disclosure, generating signal charge based on an X-ray.

An electronic apparatus according to an embodiment of the present disclosure includes the X-ray imaging element according to the embodiment of the present disclosure.

In the light-receiving element according to the embodiment of the present disclosure, the X-ray imaging element according to the embodiment of the present disclosure, and the electronic apparatus according to the embodiment of the present disclosure, the first first electrically-conductive region coupled to the first electrode and the second first electrically-conductive region coupled to the second electrode are provided at the interface of the first surface of the semiconductor substrate including the photoelectric conversion region, and the electrically-conductive film applying an electric field to the interface of the first surface is provided above the first surface of the semiconductor substrate at least between the first first electrically-conductive region and the second first electrically-conductive region. This suppresses generation of fixed electric charge and generation of an interface state near the first surface between the first first electrically-conductive region and the second first electrically-conductive region at the time of X-ray irradiation.

### Brief Description of the Drawings

[FIG. 1] FIG. 1 is a schematic cross-sectional view of an example of a configuration of a light-receiving element according to a first embodiment of the present disclosure.
[FIG. 2] FIG. 2 is a schematic plan view of an example of patterns of a p-type electrically-conductive region and a gate electrode of the light-receiving element illustrated in FIG. 1.
[FIG. 3] FIG. 3 is a schematic plan view of another example of the pattern of the p-type electrically-conductive region of the light-receiving element illustrated in FIG. 1.
[FIG. 4] FIG. 4 is a schematic plan view of another example of the pattern of the p-type electrically-conductive region of the light-receiving element illustrated in FIG. 1.
[FIG. 5] FIG. 5 is a schematic view of an example of coupling of a power supply to an n-type electrically-conductive region in the light-receiving element illustrated in FIG. 1.
[FIG. 6] FIG. 6 is a schematic view of another example of the coupling of the power supply to the n-type electrically-conductive region in the light-receiving element illustrated in FIG. 1.
[FIG. 7A] FIG. 7A is a schematic cross-sectional view of another example of the configuration of the gate electrode of the light-receiving element illustrated in FIG. 1.
[FIG. 7B] FIG. 7B is a schematic cross-sectional view of another example of the configuration of the gate electrode of the light-receiving element illustrated in FIG. 1.
[FIG. 7C] FIG. 7C is a schematic cross-sectional view of another example of the configuration of the gate electrode of the light-receiving element illustrated in FIG. 1.
[FIG. 7D] FIG. 7D is a schematic cross-sectional view of another example of the configuration of the gate electrode of the light-receiving element illustrated in FIG. 1.
[FIG. 7E] FIG. 7E is a schematic cross-sectional view of another example of the configuration of the gate electrode of the light-receiving element illustrated in FIG. 1.
[FIG. 8] FIG. 8 is a schematic cross-sectional view of another example of the configuration of the gate electrode of the light-receiving element illustrated in FIG. 1.
[FIG. 9] FIG. 9 is a schematic cross-sectional view of an example of a configuration of a light-receiving element according to Modification Example 1 of the present disclosure.
[FIG. 10] FIG. 10 is a schematic plan view of a pattern of a wiring layer of the light-receiving element illustrated in FIG. 9.
[FIG. 11] FIG. 11 is a schematic cross-sectional view of an example of a configuration of a light-receiving element according to Modification Example 2 of the present disclosure.
[FIG. 12] FIG. 12 is a schematic plan view of patterns of a gate electrode and a wiring layer of the light-receiving element illustrated in FIG. 11.
[FIG. 13] FIG. 13 is a schematic cross-sectional view of an example of a configuration of a light-receiving element according to Modification Example 3 of the present disclosure.
[FIG. 14] FIG. 14 is a schematic cross-sectional view of an example of a configuration of a light-receiving element according to Modification Example 4 of the present disclosure.
[FIG. 15] FIG. 15 is a schematic plan view of patterns of a gate electrode and a wiring layer of the light-receiving element illustrated in FIG. 14.
[FIG. 16] FIG. 16 is a schematic cross-sectional view of an example of a configuration of a light-receiving element according to Modification Example 5 of the present disclosure.
[FIG. 17] FIG. 17 is a schematic cross-sectional view of an example of a configuration of a light-receiving element according to Modification Example 6 of the present disclosure.
[FIG. 18] FIG. 18 is a schematic cross-sectional view of an example of a configuration of a light-receiving element according to a second embodiment of the present disclosure.
[FIG. 19] FIG. 19 is a schematic cross-sectional view of an example of a configuration of a light-receiving element according to Modification Example 7 of the present disclosure.
[FIG. 20] FIG. 20 is a schematic cross-sectional view of an example of a configuration of a light-receiving element according to Modification Example 8 of the present disclosure.
[FIG. 21] FIG. 21 is a schematic cross-sectional view of an example of a configuration of a light-receiving element according to a third embodiment of the present disclosure.
[FIG. 22] FIG. 22 is a block diagram illustrating a configuration of an X-ray imaging element.
[FIG. 23] FIG. 23 is a block diagram illustrating a detailed configuration example of a column selection section illustrated in FIG. 22.

### Modes for Carrying Out the Invention

In the following, description is given in detail of embodiments of the present disclosure with reference to the drawings. The following description is merely a specific example of the present disclosure, and the present disclosure should not be limited to the following aspects. Moreover, the present disclosure is not limited to arrangements, dimensions, dimensional ratios, and the like of each component illustrated in the drawings. It is to be noted that the description is given in the following order.
1. First Embodiment (An example of a light-receiving element in which a gate electrode is provided on a semiconductor substrate between an anode and a drain, and an electric field is applied to an interface of the semiconductor substrate)
   1-1. Configuration of Light-Receiving Element
   1-2. Method of Manufacturing Light-Receiving Element
   1-3. Workings and Effects
2. Modification Examples
   2-1. Modification Example 1 (An example in which a wiring layer in an insulating layer is used to apply an electric field to an interface of a semiconductor substrate)
   2-2. Modification Example 2 (An example in which a gate electrode and a wiring layer are used to apply an electric field to an interface of a semiconductor substrate)
   2-3. Modification Example 3 (Another example of a pattern of a wiring layer)
   2-4. Modification Example 4 (Another example of a pattern of a wiring layer)
   2-5. Modification Example 5 (An example in which a gate electrode and a wiring layer are short-circuited)
   2-6. Modification Example 6 (An example in which a gate electrode, a wiring layer, and a drain are short-circuited)
3. Second Embodiment (An example of a light-receiving element including, on a side of a back surface of a semiconductor substrate, a barrier layer facing an embedded layer)
4. Modification Examples
   4-1. Modification Example 7 (An example in which an anode and a barrier layer are coupled to each other)
   4-2. Modification Example 8 (An example in which regions of different impurity concentrations are provided in a barrier layer)
5. Third Embodiment (An example of a light-receiving element including a barrier layer facing an embedded layer and an electrically-conductive film that applies an electric field to an interface of a semiconductor substrate)
6. Application Example

### <1. First Embodiment>

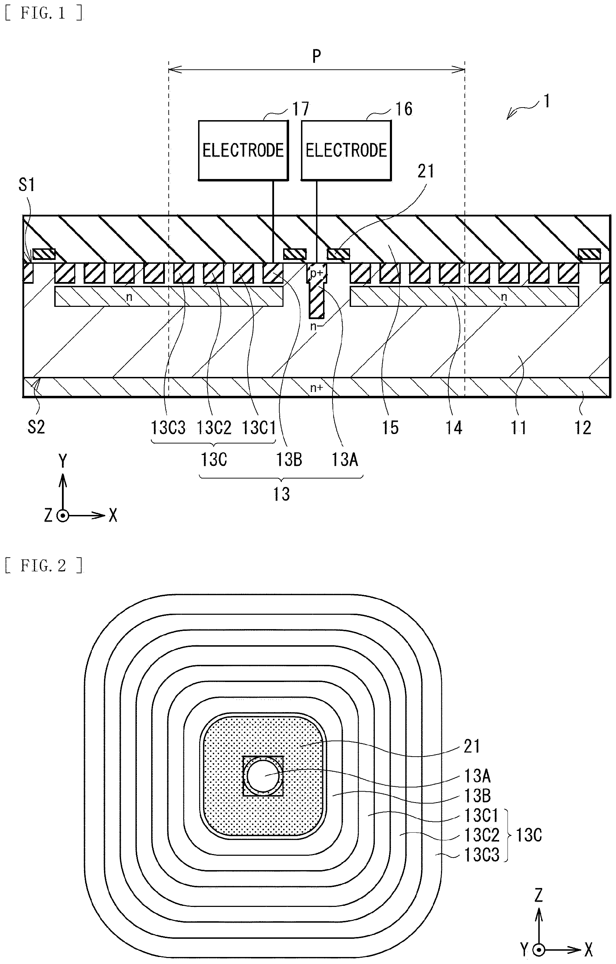

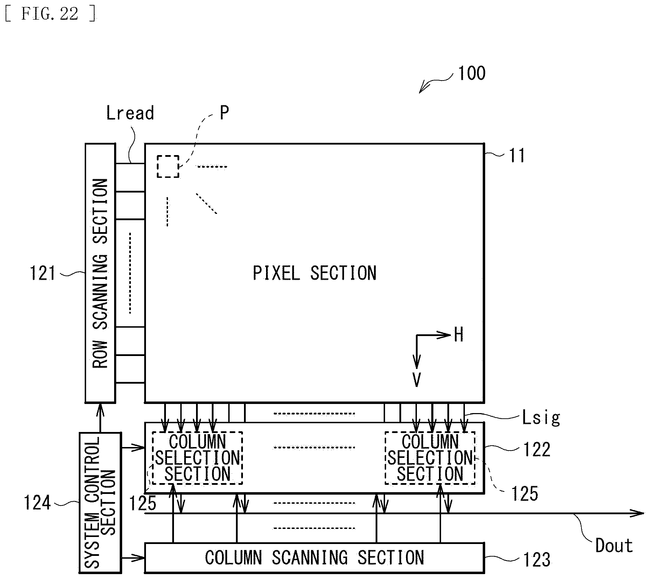

FIG. 1 schematically illustrates an example of a cross-sectional configuration of a light-receiving element (a light-receiving element 1) according to a first embodiment of the present disclosure. The light-receiving element 1 includes, for example, a PIN (Positive Intrinsic Negative) type photodiode that applies a reverse bias between a front surface and a back surface of a semiconductor substrate 11. The light-receiving element 1 constitutes one pixel (unit pixel P) in an electromagnetic wave detector or a radiation imaging element (e.g., an X-ray imaging element 100; see FIG. 22) to read information on a subject (to capture an image of a subject) on the basis of a radioactive ray (e.g., α-ray, β-ray, γ-ray, and X-ray, etc.).

### (1-1. Configuration of Light-Receiving Element)

In the light-receiving element 1, for example, a p-type electrically-conductive region (first electrically-conductive region) 13 is partially formed at an interface of a front surface S1 (first surface) of the semiconductor substrate 11 of n-type, and an n-type electrically-conductive layer (second electrically-conductive type layers) 12 is formed at an interface of a surface (a back surface S2; second surface) on a side opposite to the front surface S1. The p-type electrically-conductive region 13 includes a plurality of regions; the light-receiving element 1 includes, for example, a region (first first electrically-conductive region) constituting an anode 13A, a region (second first electrically-conductive region) constituting a drain 13B, and a region (third first electrically-conductive region) constituting a guard ring 13C. In the light-receiving element 1, an n-type electrically-conductive region (second electrically-conductive region) is further formed as an embedded layer 14 inside the semiconductor substrate 11. The light-receiving element 1 of the present embodiment further includes an insulating layer 15 on the front surface S1 of the semiconductor substrate 11 and a gate electrode 21 in the insulating layer 15 between the anode 13A and the drain 13B. The gate electrode 21 applies an electric field to the interface of the front surface S1 of the semiconductor substrate 11 between the anode 13A and the drain 13B, or reduces a volume of the insulating layer 15 provided on the semiconductor substrate 11 between the anode 13A and the drain 13B.

It is to be noted that, in the present embodiment, a description is given of a case where holes, of excitons (electron/hole pairs) generated by photoelectric conversion, are read as signal charge. In addition, in the drawings, "- (minus)" attached to "p" and "n" indicates that a p-type or n-type impurity has a low concentration, and "+ (plus)" indicates that the p-type or n-type impurity has a high concentration. The magnitude relationships among concentrations of the p-type and n-type impurities are p⁻ < p < p⁺ and n⁻ < n < n⁺, respectively.

The semiconductor substrate 11 is configured by, for example, an n-type, p-type, or i-type (intrinsic semiconductor) semiconductor, and includes, therein, a p-i-n junction or a p-n junction to serve as a photoelectric conversion region. Specifically, in the present embodiment, an n-type semiconductor substrate is used as the semiconductor substrate 11, and the p-type electrically-conductive region (first electrically-conductive region) 13 is formed at the interface of the front surface S1 as described above. A film thickness (hereinafter, simply referred to as a "thickness") of the semiconductor substrate 11 in a stacking direction (Y-axis direction) is, for example, 10 µm or more and 700 µm or less.

The p-type electrically-conductive region 13 is a region (p-type impurity region) including the p-type impurities, and a plurality of p-type electrically-conductive regions 13 is formed at the interface of the front surface S1 of the semiconductor substrate 11. Specifically, the p-type electrically-conductive region 13 includes three regions: a region constituting the anode 13A; a region constituting the drain 13B; and a region constituting the guard ring 13C. The regions are spaced apart from each other, and the drain 13B is formed in a ring shape around the anode 13A. The guard ring 13C is formed in a ring shape around the drain 13B. As for a thickness, for example, the p-type electrically-conductive region 13 is formed at a thickness of 2 µm to 3 µm, for example, from the interface of the front surface S1 of the semiconductor substrate 11, for example, in a case where a pitch of the unit pixel P is 10 µm or more and 100 µm or less, depending on a configuration of the unit pixel P.

The anode 13A receives application of a voltage to read holes (h+) as signal charge, for example, among carriers generated by photoelectric conversion; the anode 13A is coupled to an electrode 16 (first electrode), for example. For example, the anode 13A is individually formed at substantially the middle of the unit pixel P. The planar shape of the anode 13A is not particularly limited, and may be a circular shape (see, e.g., FIG. 2) or a polygonal shape. For example, the anode 13A partially protrudes to a side of the back surface S2 from a bottom surface of the embedded layer 14 described later. A size of the anode 13A is, for example, 0.1 µm or more and 10 µm or less in a case where the pitch of the unit pixel P is 10 µm or more and 100 µm or less, for example, depending on a size of the unit pixel P.

The drain 13B receives application of a voltage to discharge a dark current generated at the interface of the front surface S1 at the time of irradiation of the semiconductor substrate 11 with light; the drain 13B is coupled to, for example, an electrode 17 (second electrode). The drain 13B is formed in a ring shape around the anode 13A, and the dark current generated at the interface of the front surface S1 at the time of the irradiation of the semiconductor substrate 11 with light is constantly discharged from the drain 13B. This makes it possible to prevent the dark current from flowing into the anode 13A. A planar shape of the drain 13B is not particularly limited, and may be an annular shape or a polygonal shape (see, e.g., FIG. 2).

The guard ring 13C is provided to generate a horizontal electric field that alleviates the concentration of an electric field on the drain 13B and simultaneously assists transportation of signal charge (holes) in a horizontal direction (e.g., X-Y plane direction). The guard ring 13C is formed in a ring shape around the drain 13B to surround the anode 13A and the drain 13B. Unlike the anode 13A and drain 13B, the guard ring 13C is in an electrically floating state. For example, a plurality of guard rings 13C is formed at the interface of the front surface S1 of the semiconductor substrate 11. Specifically, as illustrated in FIGs. 1 and 2, the guard ring 13C includes, for example, three p-type electrically-conductive regions, and is formed triply (guard rings 13C1, 13C2, and 13C3) around the drain 13B. In this manner, providing the plurality of guard rings 13C enables the concentrated electric field to be distributed to a plurality of locations and at the same time to generate the horizontal electric field in a wide region.

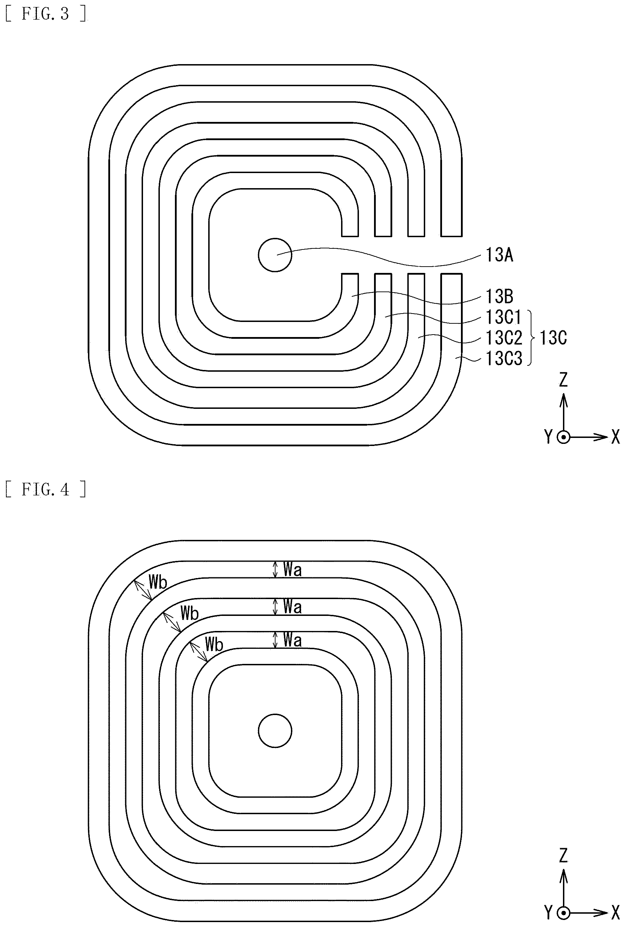

In a case where the drain 13B and the guard ring 13C have a polygonal shape (e.g., a rectangle shape), the corners are preferably formed to have a curved shape as illustrated in FIG. 2. This allows the concentration of the electric field at the corners to be alleviated. In addition, although FIG. 2 exemplifies the drain 13B and the guard ring 13C being continuously provided around the anode 13A, this is not limitative. For example, as illustrated in FIG. 3, a portion thereof may be cut. Alternatively, they may be formed intermittently.

A linewidth of the ring constituting the drain 13B and the guard ring 13C is, for example, 0.100 µm or more and 10 µm or less. An interval between the drain 13B and the guard ring 13C is, for example, 0.100 µm or more and 10 µm or less. However, the interval between the drain 13B and the guard ring 13C and the line width of the drain 13B and the guard ring 13C are not necessarily constant. For example, in a case where the drain 13B and the plurality of guard rings 13C are each polygonal (e.g., rectangular), the intervals between the drain 13B and the guard ring 13C and among the guard rings 13C1, 13C2, and 13C3 may be formed to allow the corner (Wb) to be wider than a straight part (Wa) as illustrated in FIG. 4. This further alleviates the concentration of the electric field at the corners.

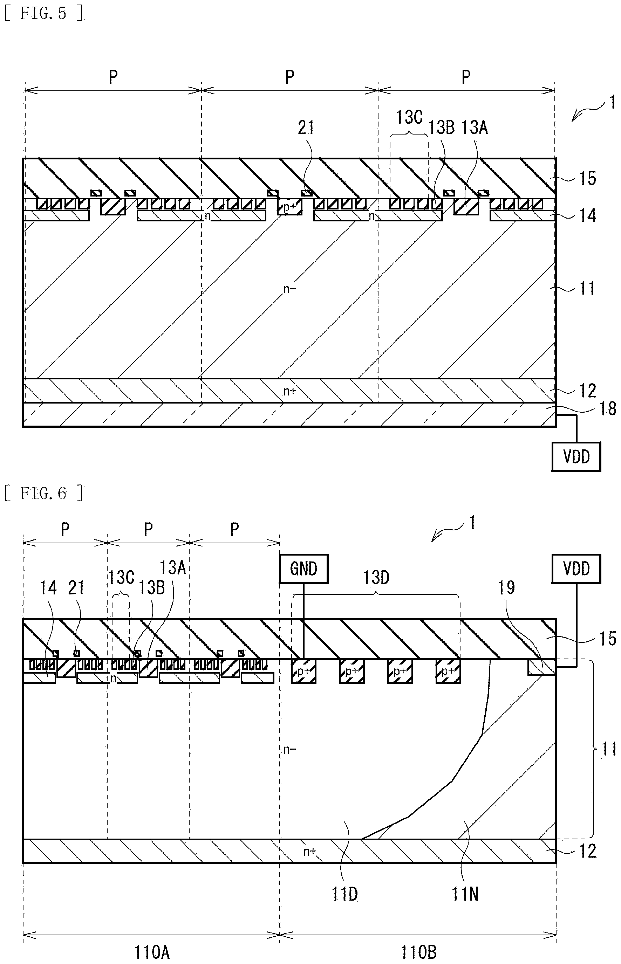

The n-type electrically-conductive layer 12 is a region (n-type impurity region) including n-type impurities having a concentration higher than those of the n-type semiconductor substrate 11, and is formed at an interface of the back surface S2 of the semiconductor substrate 11. For example, a power supply VDD (see FIG. 5) is coupled to the n-type electrically-conductive layer 12. In a case where, for example, holes, among carriers generated by photoelectric conversion, are read as signal charge through the anode 13A, electrons (e-) are discharged through the n-type electrically-conductive layer 12. As for a thickness, for example, the n-type electrically-conductive layer 12 is formed at a thickness of 1 µm, for example, from the interface of the back surface S2 of the semiconductor substrate 11, for example, in a case where the pitch of the unit pixel P is 10 µm or more and 100 µm or less, depending on the configuration of the unit pixel P.

FIGs. 5 and 6 each illustrate an example of a method of coupling a power supply to the n-type electrically-conductive layer 12. FIG. 5 illustrates an example in which a transparent electrode 18 is formed on the n-type electrically-conductive layer 12, and the power supply VDD is coupled to the transparent electrode 18 to apply a voltage from the side of the back surface S2 of the semiconductor substrate 11. FIG. 6 illustrates an example in which, in a peripheral region 110B around a pixel region 110A where a plurality of unit pixels P are arranged in matrix, for example, a neutral region 11N is formed outside a depletion region 11D formed in the semiconductor substrate 11, through which a voltage is applied via an n-type electrically-conductive region 19 provided at the interface of the front surface S1 of the semiconductor substrate 11. It is to be noted that, in this case, as illustrated in FIG. 6, it is preferable to form a plurality of high-voltage guard rings 13D between the n-type electrically-conductive region 19 and the unit pixel P formed in the pixel region 110A at the interface of the front surface S1 of the semiconductor substrate 11 in the peripheral region 110B. Among the plurality of high-voltage guard rings 13D, a high-voltage guard ring arranged closest to the pixel region 110A is preferably coupled to a ground GND.

The embedded layer 14 is provided to prevent carriers (here, signal charge (holes)) generated in the semiconductor substrate 11 by photoelectric conversion from being transferred to the drain 13B or the guard ring 13C. The embedded layer 14 is an n-type electrically-conductive region including n-type impurities of higher concentration than those of the n-type semiconductor substrate 11 and embedded inside the semiconductor substrate 11, specifically, near the p-type electrically-conductive region 13. More particularly, the embedded layer 14 is provided in a region corresponding to the drain 13B and the guard ring 13C, of the p-type electrically-conductive region 13, and has an opening in a region facing the anode 13A. This allows signal charge (holes) generated in the semiconductor substrate 11 to be efficiently read from the anode 13A. It is to be noted that the embedded layer 14 is formed not to be in direct contact with the drain 13B and the guard ring 13C. A thickness of the embedded layer 14 is, for example, 0.100 µm or more and 10 µm or less, although it varies depending on the magnitude of an applied reverse bias voltage to be applied between the front surface S1 and the back surface S2 of the semiconductor substrate 11.

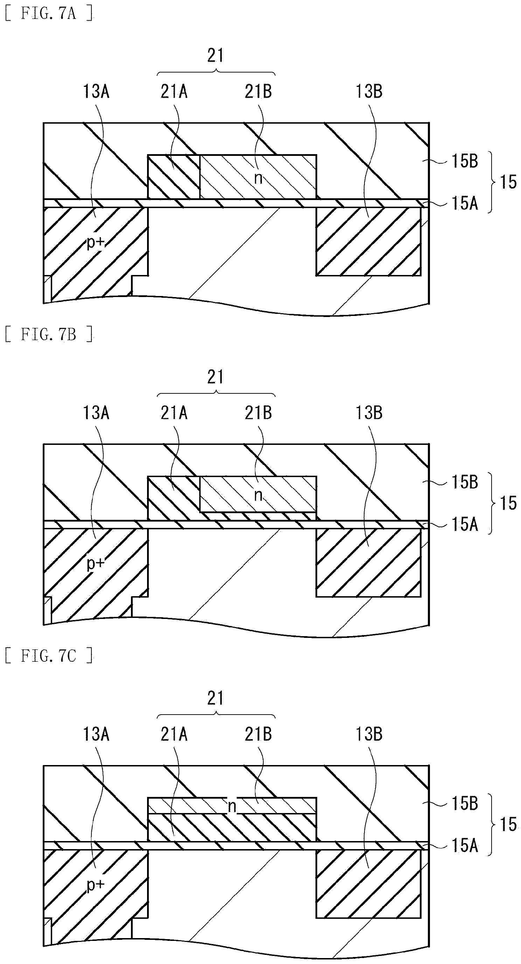

The insulating layer 15 is formed on the front surface S1 of the semiconductor substrate 11. In the insulating layer 15, for example, a gate insulating film 15A and an interlayer insulating film 15B are formed in this order from a side of the semiconductor substrate 11, and the gate electrode 21 described above is provided on the gate insulating film 15A (see, e.g., FIG. 7A). The insulating layer 15 including the gate insulating film 15A and the interlayer insulating film 15B is formed using an inorganic insulating material. Examples of the inorganic insulating material include silicon oxide (SiOz), silicon nitride (SiN), aluminum oxide (Al₂O₃), and hafnium oxide (HfO₂). The insulating layer 15 is formed to include at least one of these materials.

The gate electrode 21 is provided to apply an electric field to the interface of the front surface S1 of the semiconductor substrate 11 between the anode 13A and the drain 13B, for example, as described above. Specifically, the gate electrode 21 applies an electric field in a direction to distance holes, generated near the interface of the front surface S1 of the semiconductor substrate 11, away from the semiconductor substrate 11. More specifically, a minus (-) voltage with respect to a potential of the semiconductor substrate 11 is applied to the gate electrode 21, thereby applying an electric field of, for example, 0.5 MV/cm or more to the interface of the front surface S1 of the semiconductor substrate 11. In addition, the gate electrode 21 is provided to reduce the volume of the insulating layer 15 provided on the semiconductor substrate 11 between the anode 13A and the drain 13B, for example. This reduces an increase in positive fixed electric charge generated near the interface of the insulating layer 15 with the front surface S1 of the semiconductor substrate 11 due to X-ray irradiation as well as an increase in an interface state of the front surface S1 of the semiconductor substrate 11.

It is to be noted that, as described above, the gate electrode 21 applies an electric field to the interface of the front surface S1 of the semiconductor substrate 11 between the anode 13A and the drain 13B and/or reduces the volume of the insulating layer 15 provided on the semiconductor substrate 11 between the anode 13A and the drain 13B. The gate electrode 21 may not necessarily involve a gate operation, and is referred to herein as the "gate electrode" for the sake of convenience.

For example, as illustrated in FIG. 2, the gate electrode 21 is provided between the anode 13A and the drain 13B, with the gate insulating film 15A interposed therebetween, to surround the anode 13A in a plan view. The gate electrode 21 can be formed using, for example, polysilicon (poly-Si). The polysilicon constituting the gate electrode 21 may be an intrinsic semiconductor including no impurities or an impurity semiconductor including n-type or p-type impurities. In addition thereto, the polysilicon constituting the gate electrode 21 may include a plurality of semiconductor regions having different impurity concentrations, for example. Specifically, the polysilicon may have a first region 21A including no or almost no impurities and a second region 21B having an impurity concentration higher than that of the first region 21A. The first region 21A and the second region 21B are formed as follows, for example.

For example, as illustrated in FIG. 7A, the first region 21A may be formed on a side of the anode 13A, and, for example, the second region 21B of n-type may be formed on a side of the drain 13B. This alleviates the electric field, which may possibly be a source of a dark current, between the anode 13A and an end part of the gate electrode 21 on the side of the anode 13A, and reduces degradation of an insulating film (gate insulating film 15A) of that part in withstanding a voltage.

In addition, as illustrated in FIG. 7B, the first region 21A may extend from a side surface on the side of the anode 13A to below the n-type second region 21B (between the second region 21B and the gate insulating film 15A). Alternatively, for example, as illustrated in FIG. 7C, the first region 21A and the n-type second region 21B may be stacked in this order from a side of the gate insulating film 15A. In this manner, providing the first region 21A between the gate insulating film 15A and the second region 21B alleviates the entire electric field below the gate electrode 21 and further reduces the degradation of the gate insulating film 15A in withstanding a voltage.

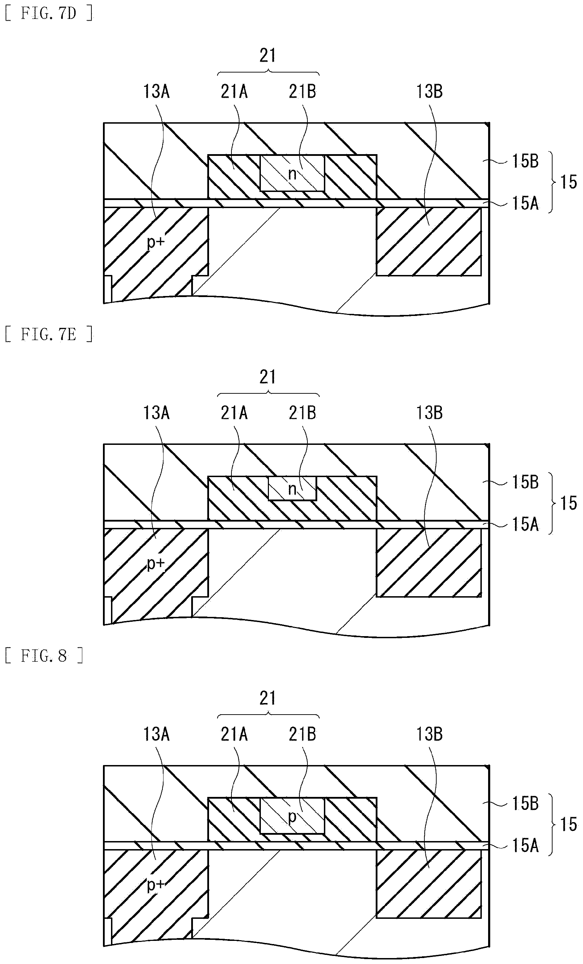

Further, for example, as illustrated in FIG. 7D, the first region 21A may be provided also on the side of the drain 13B. This alleviates an electric field between the drain 13B and the end part of the gate electrode 21 on the side of the drain 13B. Furthermore, as illustrated in FIG. 7E, for example, the entire polysilicon may be set as the first region 21A, and the n-type second region 21B may be locally provided only in a contact part with a wiring line. This further alleviates the entire electric field below the gate electrode 21.

It is to be noted that impurities included in the second region 21B are not limited to the n-type impurities; the second region 21B may be, for example, a p-type impurity region in which p-type impurities are introduced into polysilicon, as illustrated in FIG. 8. In this manner, the use of the p-type impurities further alleviates the electric field below the gate electrode 21, as compared with the case where the n-type impurities are used, thus making it possible to further reduce the generation of a dark current as well as the degradation of the gate insulating film 15A in withstanding a voltage.

Although not illustrated, for example, a substrate in which the above-described electrodes 16 and 17, a logic circuit, and the like are formed is disposed on the insulating layer 15.

### (1-2. Method of Manufacturing Light-Receiving Element)

The light-receiving element 1 can be produced, for example, as follows. First, the n-type electrically-conductive layer 12 is formed on the back surface S2 of the semiconductor substrate 11 using an ion implantation technique. Subsequently, a mask is formed on a predetermined region of the front surface S1 of the semiconductor substrate 11, and then n-type impurities (e.g., phosphorus (P)) are doped using an ion implantation technology to form an n-type electrically-conductive region (embedded layer 14). Next, a mask is formed on a predetermined region of the front surface S1 of the semiconductor substrate 11, and then p-type impurities (e.g., boron (B)) are doped using an ion implantation technology to form p-type electrically-conductive regions (anode 13A, drain 13B, and guard ring 13C). Subsequently, the gate insulating film 15A is formed on the front surface S1 of the semiconductor substrate 11 using a CVD (Chemical Vapor Deposition) method, for example. Next, a polysilicon film is formed on the gate insulating film 15A using a CVD method, for example, and then the polysilicon film is patterned using a photolithography method, for example, to form the gate electrode 21 between the anode 13A and the drain 13B. Thereafter, the first region 21A and the second region 21B are formed appropriately in the gate electrode 21 using an ion implantation technology. Finally, the interlayer insulating film 15B is formed using a CVD method, for example, to form the insulating layer 15. This completes the light-receiving element 1 illustrated in FIG. 1.

### (1-3. Workings and Effects)

In the light-receiving element 1 of the present embodiment, the anode 13A coupled to the electrode 16 and the drain 13B coupled to the electrode 17 are provided at the interface of the front surface S1 of the semiconductor substrate 11 including the photoelectric conversion region. Further, the gate electrode 21 is provided on the front surface S1 of the semiconductor substrate 11 between the anode 13A and the drain 13B, with the gate insulating film 15A interposed therebetween. This suppresses, at the time of X-ray irradiation, the generation of an interface state and the generation of a fixed electric charge on the front surface S1 of the semiconductor substrate 11 between the anode 13A and the drain 13B. This is described below.

As described above, solid-state imaging devices are used in various applications including, for example, an imaging device such as a digital still camera or a video camera, an electronic apparatus such as a mobile terminal apparatus having an imaging function, or an electromagnetic wave sensor that detects various wavelengths other than that of visible light. In these solid-state imaging devices, a CMOS image sensor has been widely used that reads signal charge accumulated in a photodiode, as a photoelectric conversion element, via a MOS transistor.

A unit pixel of the CMOS image sensor includes, in a semiconductor substrate, for example, a photodiode (PD) including an HAD (Hole Accumulated Diode) structure and a floating diffusion region (FD) disposed at a position across the photodiode with a transfer gate interposed therebetween. In addition thereto, the unit pixel includes, for example, a reset transistor, a select transistor, and an amplifier transistor.

In addition, examples of another form of the unit pixel of the CMOS image sensor include a structure in which the photoelectric conversion region and the FD are integrated in a semiconductor substrate without including the HAD. In addition to being simple and easy to be manufactured, this structure is able to add any potential difference to a p-n junction that forms the photoelectric conversion region. Therefore, it is easy to increase the thickness of the photoelectric conversion region, and thus the structure has often been used, by taking advantage thereof, in a sensor for scientific use that requires high sensitivity measurement.

Incidentally, in the CMOS image sensor having the structure in which the photoelectric conversion region and the FD are integrated in the semiconductor substrate without including the HAD, a surface of the semiconductor substrate is in contact with a depletion layer. Accordingly, in a case where a strong radioactive ray such as an X-ray is irradiated thereto, for example, fixed electric charge is generated at an insulating film provided on the semiconductor substrate or at an interface thereof to thereby cause a capacity or an electric field to greatly fluctuate. Therefore, an improvement in resistance to high energy input has been required.

In contrast, in the present embodiment, the gate electrode 21 is provided on the front surface S1 of the semiconductor substrate 11 between the anode 13A and the drain 13B provided at the interface of the front surface S1 of the semiconductor substrate 11, with the gate insulating film 15A interposed therebetween. This reduces the volume of the insulating layer 15 provided on the semiconductor substrate 11 between the anode 13A and the drain 13B, and reduces a volume of electron-hole pairs generated by X-ray irradiation near the interface of the insulating layer 15 with the front surface S1 of the semiconductor substrate 11. In addition, in a case where, for example, a minus (-) voltage is applied to the gate electrode 21 and an electric field is applied to the interface of the front surface S1 of the semiconductor substrate 11, electric charge (e.g., holes) is discharged that is generated by X-ray irradiation in the insulating layer (insulating layer 15) near the interface of the insulating layer 15 with the front surface S1 of the semiconductor substrate 11.

As described above, in the light-receiving element 1 of the present embodiment, the gate electrode 21 is provided on the front surface S1 of the semiconductor substrate 11 between the anode 13A and the drain 13B provided at the interface of the front surface S1 of the semiconductor substrate 11, with the gate insulating film 15A interposed therebetween. This reduces an increase in positive fixed electric charge generated at the interface of the front surface S1 of the semiconductor substrate 11 upon X-ray irradiation. It is therefore possible to reduce the fluctuations in a capacity of the anode and an electric field at the interface of the front surface S1 of the semiconductor substrate 11. In addition thereto, the generation of an interface state on the front surface S1 of the semiconductor substrate 11 is suppressed. It is therefore possible to reduce the generation of a dark current. That is, it is possible to implement a light-receiving element having high resistance to the fluctuations in a capacity and an electric field due to X-ray irradiation.

In addition, in the light-receiving element 1 of the present embodiment, the gate electrode 21 is formed using polysilicon, and the first region 21A including no or almost no impurities in polysilicon and a semiconductor region 22B having an impurity concentration higher than that of the first region 21A are provided. Specifically, the first region 21A is formed near the anode 13A or on the side of the gate insulating film 15A, and the semiconductor region 22B is partially provided. This reduces a degradation of the gate insulating film 15A in withstanding a voltage or an increase in the dark current due to an excessively strong electric field below the gate electrode 21. That is, it is possible to achieve a reduction in the generation of a dark current and an improvement of the insulating film in withstanding a voltage, while improving the resistance to an X-ray.

Next, descriptions are given of second and third embodiments, Modification Examples 1 to 8, and an application example. Hereinafter, components similar to those of the foregoing first embodiment are denoted by the same reference numerals, and descriptions thereof are omitted as appropriate.

### <2. Modification Examples>

### (2-1. Modification Example 1)

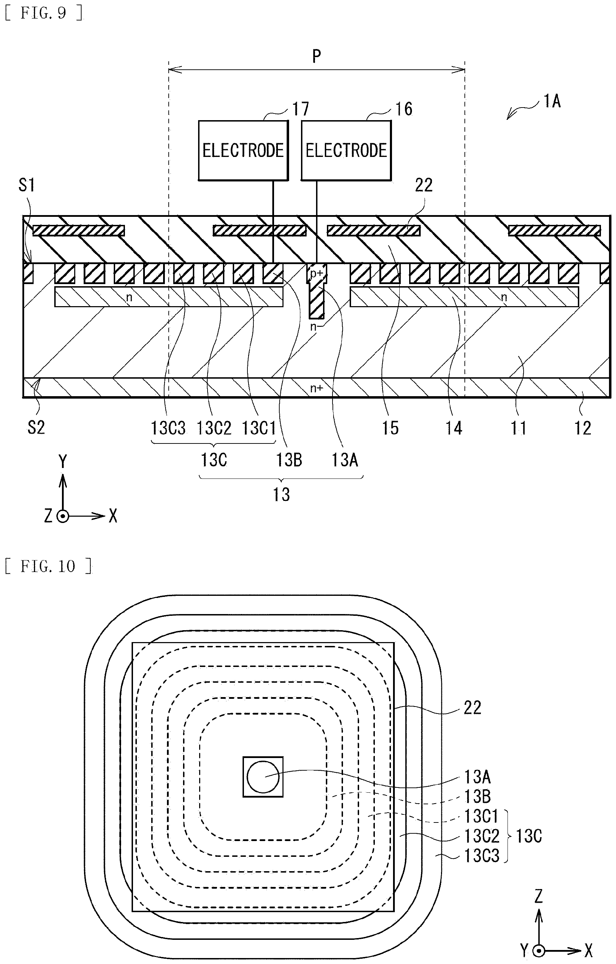

FIG. 9 schematically illustrates an example of a cross-sectional configuration of a light-receiving element (a light-receiving element 1A) according to Modification Example 1 of the present disclosure. In the same manner as the foregoing first embodiment, the light-receiving element 1A includes, for example, a PIN type photodiode that applies a reverse bias between the front surface and the back surface of the semiconductor substrate 11. The light-receiving element 1A constitutes one pixel (unit pixel P) in an electromagnetic wave detector or a radiation imaging element (e.g., X-ray imaging element 100) to read information on a subject (to capture an image of a subject) on the basis of a radioactive ray (e.g., α-ray, β-ray, γ-ray, and X-ray, etc.). The light-receiving element 1A of the present modification example differs from the foregoing first embodiment in that a wiring layer 22 formed in the interlayer insulating film 15B is used instead of the gate electrode 21 to apply an electric field to an interface of the front surface S1 of the semiconductor substrate 11, or in that the volume of the insulating layer 15 provided on the semiconductor substrate 11 between the anode 13A and the drain 13B is reduced.

As described above, the wiring layer 22 is provided to apply an electric field to the interface of the front surface S1 of the semiconductor substrate 11. For example, a minus (-) voltage with respect to the potential of the semiconductor substrate 11 is applied to the wiring layer 22, and an electric field of, for example, 0.5 MV/cm or more is applied to the interface of the front surface S1 of the semiconductor substrate 11. In addition, the wiring layer 22 is provided, for example, to reduce the volume of the insulating layer 15 provided on the semiconductor substrate 11 between the anode 13A and the drain 13B. The wiring layer 22 is provided in the interlayer insulating film 15B, and extends, for example, from between the anode 13A and the drain 13B to a portion of the guard ring 13C, as illustrated in FIG. 10, for example. The wiring layer 22 is formed using a metal material such as aluminum (Al), copper (Cu), or tungsten (W), for example.

Thus, in the present modification example, the wiring layer 22 provided in the interlayer insulating film 15B and extending, for example, from between the anode 13A and the drain 13B to a portion of the guard ring 13C is used to apply an electric field to the interface of the front surface S1 of the semiconductor substrate 11 or to reduce the volume of the insulating layer 15 provided on the semiconductor substrate 11 between the anode 13A and the drain 13B. This reduces an increase in positive fixed electric charge generated at the interface of the front surface S1 of the semiconductor substrate 11 upon X-ray irradiation, in the same manner as the foregoing first embodiment. It is therefore possible to reduce the fluctuations in a capacity of the anode and an electric field at the interface of the front surface S1 of the semiconductor substrate 11. That is, it is possible to implement a light-receiving element having high resistance to the fluctuations in a capacity and an electric field due to X-ray irradiation.

### (2-2. Modification Example 2)

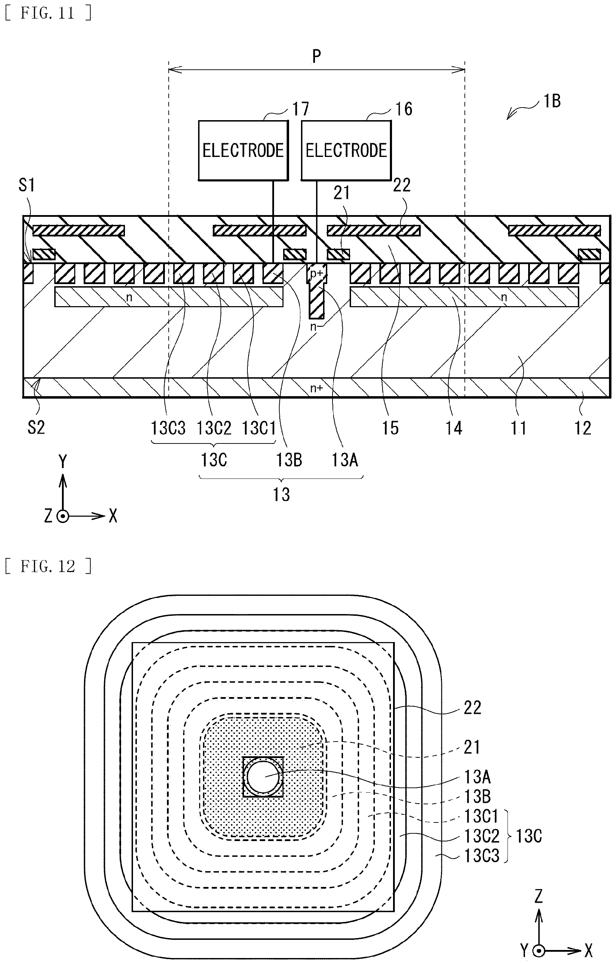

FIG. 11 schematically illustrates an example of a cross-sectional configuration of a light-receiving element (a light-receiving element 1B) according to Modification Example 2 of the present disclosure. FIG. 12 schematically illustrates a planar pattern of the wiring layer 22 illustrated in FIG. 11. The foregoing Modification Example 1 exemplifies the use of the wiring layer 22 extending from between the anode 13A and the drain 13B to a portion of the guard ring 13C, instead of the gate electrode 21, to apply an electric field to the interface of the front surface S1 of the semiconductor substrate 11 or to reduce the volume of the insulating layer 15 provided on the semiconductor substrate 11 between the anode 13A and the drain 13B. However, a configuration may also be adopted in which the foregoing first embodiment and Modification Example 1 are combined.

That is, the gate electrode 21 provided on the front surface S1 of the semiconductor substrate 11 between the anode 13A and the drain 13B with the gate insulating film 15A interposed therebetween and the wiring layer 22 provided in the interlayer insulating film 15B and extending from between the anode 13A and the drain 13B to a portion of the guard ring 13C may be used to apply an electric field to the interface of the front surface S1 of the semiconductor substrate 11 or to reduce the volume of the insulating layer 15 provided on the semiconductor substrate 11 between the anode 13A and the drain 13B. Also in this case, in the same manner as the foregoing first embodiment, an increase in positive fixed electric charge generated at the interface of the front surface S1 of the semiconductor substrate 11 upon X-ray irradiation is reduced. It is therefore possible to reduce the fluctuation in an electric field at the interface of the front surface S1 of the semiconductor substrate 11. That is, it is possible to implement a light-receiving element having high resistance to the fluctuations in a capacity and an electric field due to X-ray irradiation.

### (2-3. Modification Example 3)

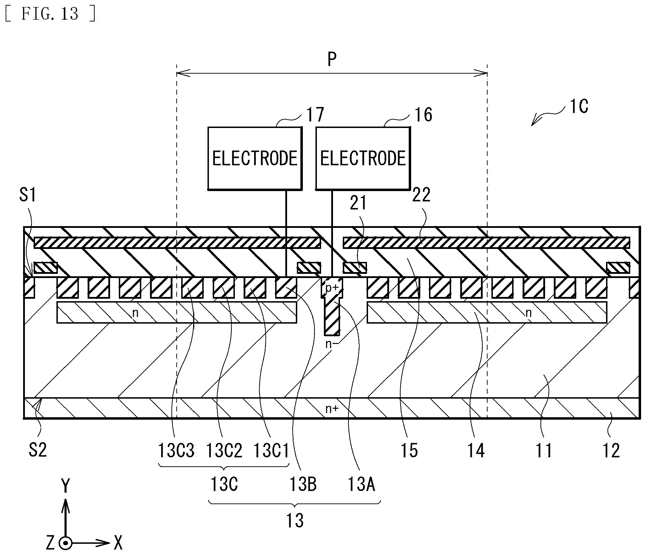

FIG. 13 schematically illustrates an example of a cross-sectional configuration of a light-receiving element (a light-receiving element 1C) according to Modification Example 3 of the present disclosure. The foregoing Modification Example 1 and Modification Example 2 exemplify the use of a wiring line, as the wiring layer 22, to cover an area from between the anode 13A and the drain 13B to a portion of the guard ring 13C; however, the pattern of the wiring layer 22 is not limited thereto.

For example, as illustrated in FIG. 13, a wiring layer may be provided that covers all of the guard rings 13C from between the anode 13A and the drain 13B. In other words, a wiring layer may be provided that extends continuously across the unit pixels P adjacent to each other except an area above the anode 13A, and the wiring layer may be used as the wiring layer 22. Also in this case, in the same manner as the foregoing first embodiment, an increase in positive fixed electric charge generated at the interface of the front surface S1 of the semiconductor substrate 11 upon X-ray irradiation is reduced. It is therefore possible to reduce the fluctuation in an electric field at the interface of the front surface S1 of the semiconductor substrate 11. That is, it is possible to implement a light-receiving element having high resistance to the fluctuations in a capacity and an electric field due to X-ray irradiation.

### (2-4. Modification Example 4)

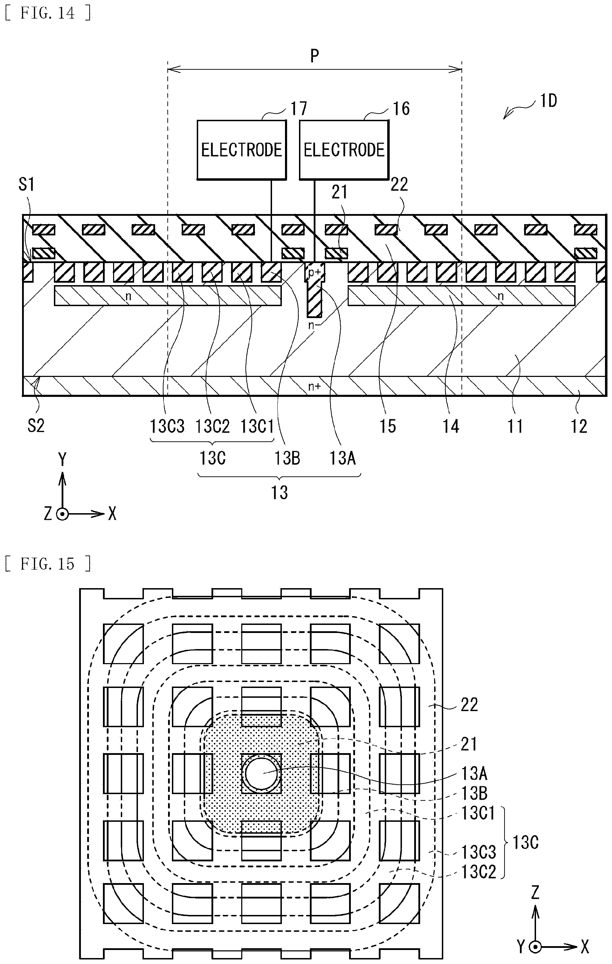

FIG. 14 schematically illustrates an example of a cross-sectional configuration of a light-receiving element (a light-receiving element 1D) according to Modification Example 4 of the present disclosure. FIG. 15 schematically illustrates a planar pattern of the wiring layer 22 illustrated in FIG. 14. The foregoing Modification Example 2 exemplifies the use of the wiring layer, as the wiring layer 22, extending continuously and uniformly across the unit pixels P adjacent to each other except an area above the anode 13A. However, this wiring layer may be patterned into a grid shape as illustrated in FIG. 15, for example.

### (2-5. Modification Example 5)

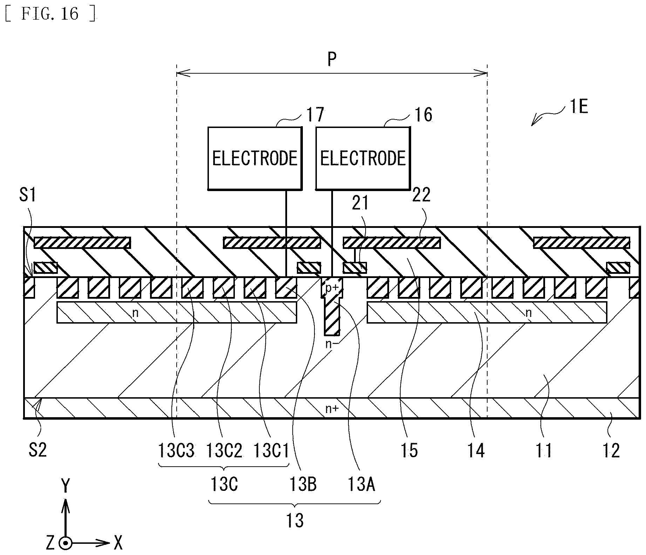

FIG. 16 illustrates an example of a cross-sectional configuration of a light-receiving element (a light-receiving element 1E) according to Modification Example 5 of the present disclosure. As illustrated in FIG. 16, the gate electrode 21 and the wiring layer 22 may be short-circuited. This makes it possible to reduce the number of wiring lines extending in a Z-axis direction and the number of terminals in the insulating layer 15.

### (2-6. Modification Example 6)

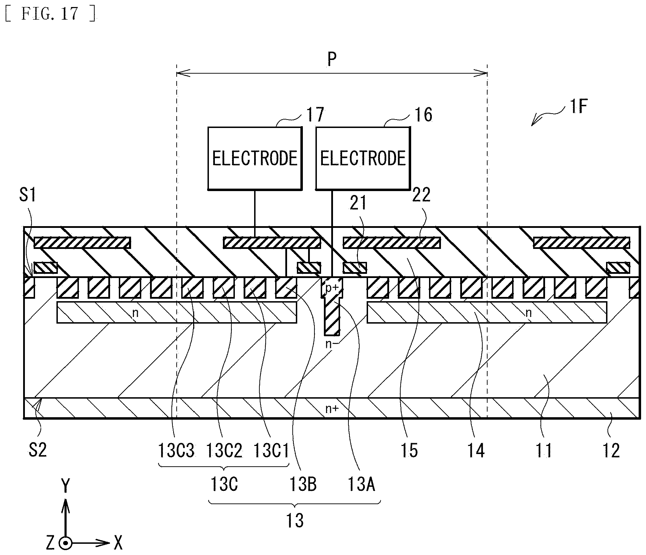

FIG. 17 illustrates an example of a cross-sectional configuration of a light-receiving element (a light-receiving element 1F) according to Modification Example 6 of the present disclosure. As illustrated in FIG. 17, the drain 13B may be short-circuited together with the gate electrode 21 and the wiring layer 22. This makes it possible to further reduce the number of wiring lines extending in the Z-axis direction and the number of terminals in the insulating layer 15.

### < 3. Second Embodiment>

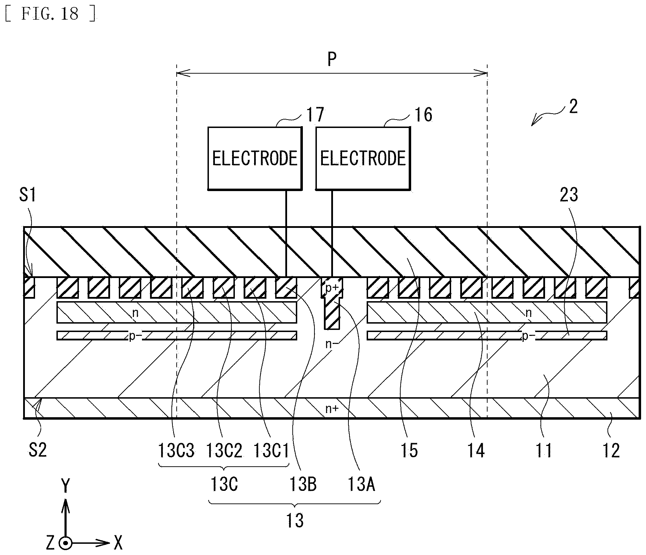

FIG. 18 schematically illustrates an example of a cross-sectional configuration of a light-receiving element (a light-receiving element 2) according to a second embodiment of the present disclosure. In the same manner as the foregoing first embodiment, the light-receiving element 2 includes, for example, a PIN type photodiode that applies a reverse bias between the front surface and the back surface of the semiconductor substrate 11. The light-receiving element 2 constitutes one pixel (unit pixel P) in an electromagnetic wave detector or a radiation imaging element (e.g., X-ray imaging element 100) to read information on a subject (to capture an image of a subject) on the basis of a radioactive ray (e.g., α-ray, β-ray, γ-ray, and X-ray, etc.).

In the light-receiving element 2, for example, the p-type electrically-conductive region 13 is formed partially at an interface of the front surface S1 of the n-type semiconductor substrate 11, and the n-type electrically-conductive layer 12 is formed at an interface of the surface (back surface S2) on the side opposite to the front surface S1. The p-type electrically-conductive region 13 is configured by a plurality of regions; the light-receiving element 2 includes, for example, a region constituting the anode 13A, a region constituting the drain 13B, and a region constituting the guard ring 13C. In the light-receiving element 2, an n-type electrically-conductive region is further formed as the embedded layer 14 inside the semiconductor substrate 11. In the light-receiving element 2 of the present embodiment, a barrier layer 23 is further formed at a position facing the embedded layer 14 inside the semiconductor substrate 11 on a side opposite to a side of the p-type electrically-conductive region 13.

The barrier layer 23 is provided to prevent carriers (here, signal charge (holes)) generated in the semiconductor substrate 11 by photoelectric conversion from being transferred to the drain 13B or the guard ring 13C. In addition, the barrier layer 23 is provided not to cause carriers generated in the semiconductor substrate 11 by photoelectric conversion to be lost to the drain 13B from the guard ring 13C. As described above, the barrier layer 23 is a p-type electrically-conductive region (fourth first electrically-conductive region) provided at a position facing the embedded layer 14 inside the semiconductor substrate 11 on the side opposite to the side of the p-type electrically-conductive region 13. This p-type electrically-conductive region has an impurity (e.g., B (boron)) concentration lower than an impurity concentration of the p-type electrically-conductive region that forms the anode 13A, the drain 13B, and the guard ring 13C to allow for depletion. For example, the p-type electrically-conductive region has a low concentration of about 1e10 cm⁻² to about 1e12 cm⁻².

In the light-receiving element 1 or the like, the embedded layer 14 is formed near the p-type electrically-conductive region 13 inside the semiconductor substrate 11. In the same manner as the barrier layer 23 of the present embodiment, this embedded layer 14 is provided to prevent carriers (here, signal charge (holes)) generated in the semiconductor substrate 11 by photoelectric conversion from being transferred to the drain 13B or the guard ring 13C. The embedded layer 14 is an n-type electrically-conductive region including n-type impurities having a concentration higher than that of the n-type semiconductor substrate 11, and is a potential barrier due to a concentration difference between the n-type impurity concentration of the semiconductor substrate 11 and the n-type impurity concentration of the embedded layer 14. Therefore, in a case where dispersion occurs in the impurity concentration of the semiconductor substrate 11, a desired effect may possibly not be obtained. The potential barrier by the embedded layer 14 can be enhanced by increasing the impurity concentration of the n-type electrically-conductive region constituting the embedded layer 14; however, in this case, potentials of the embedded layer 14 and the front surface S1 of the semiconductor substrate 11 are increased, thus causing the front surface S1 of the semiconductor substrate 11 to have lower performance in withstanding a voltage.

In contrast, in the light-receiving element 2 of the present embodiment, the barrier layer 23 including the p-type electrically-conductive region is provided at a position facing the embedded layer 14 inside the semiconductor substrate 11 on the side opposite to the side of the p-type electrically-conductive region 13. This enhances a potential barrier to carriers (here, signal charge (holes)) generated in the semiconductor substrate 11 by photoelectric conversion, thus making it possible to further prevent signal charge (holes) from being transferred to the drain 13B or the guard ring 13C. It is therefore possible to further improve transfer efficiency of the signal charge (holes) generated in the semiconductor substrate 11.

In addition, in the present embodiment, the barrier layer 23 is set as a p-type electrically-conductive region of a low concentration allowing for depletion, and thus formation of an electric field in the horizontal direction (e.g., X-Y plane direction) is not inhibited. It is therefore possible to prevent deterioration in the transfer efficiency of the signal charge (holes), and to suppress generation of color mixture between the unit pixels P adjacent to each other. In addition, it is also possible to prevent degradation of S/N ratio due to deterioration in conversion efficiency caused by an increase in a capacity of the anode 13A.

### <4. Modification Examples>

### (4-1. Modification Example 7)

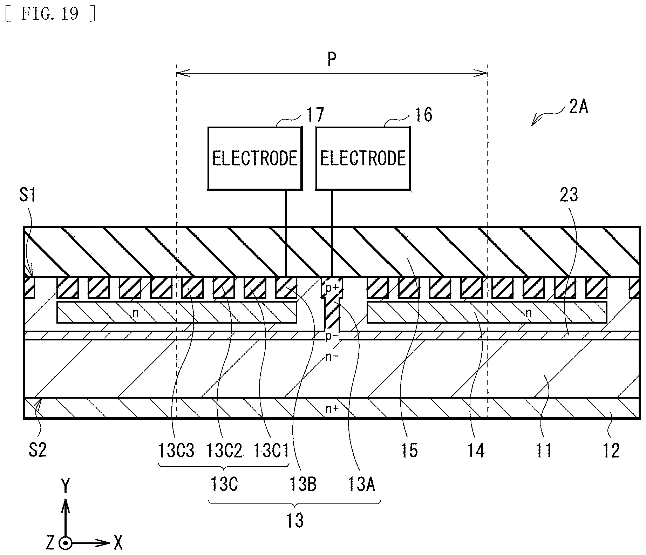

FIG. 19 schematically illustrates an example of a cross-sectional configuration of a light-receiving element (a light-receiving element 2A) according to Modification Example 7 of the present disclosure. In the same manner as the foregoing first embodiment, the light-receiving element 2A includes, for example, a PIN type photodiode that applies a reverse bias between the front surface and the back surface of the semiconductor substrate 11. The light-receiving element 2A constitutes one pixel (unit pixel P) in an electromagnetic wave detector or a radiation imaging element (e.g., X-ray imaging element 100) to read information on a subject (to capture an image of a subject) on the basis of a radioactive ray (e.g., α-ray, β-ray, γ-ray, and X-ray, etc.). The light-receiving element 2A of the present modification example differs from the foregoing second embodiment in that the barrier layer 23 is formed to extend across the entire unit pixel P and is further coupled to the anode 13A.

In this manner, in the present modification example, the barrier layer 23 is formed across the entire unit pixel P, and the barrier layer 23 and the anode 13A are coupled to each other, thus making it possible to further prevent signal charge (holes) from being transferred to the drain 13B or the guard ring 13C, as compared with the effects of the foregoing second embodiment.

### (4-2. Modification Example 8)

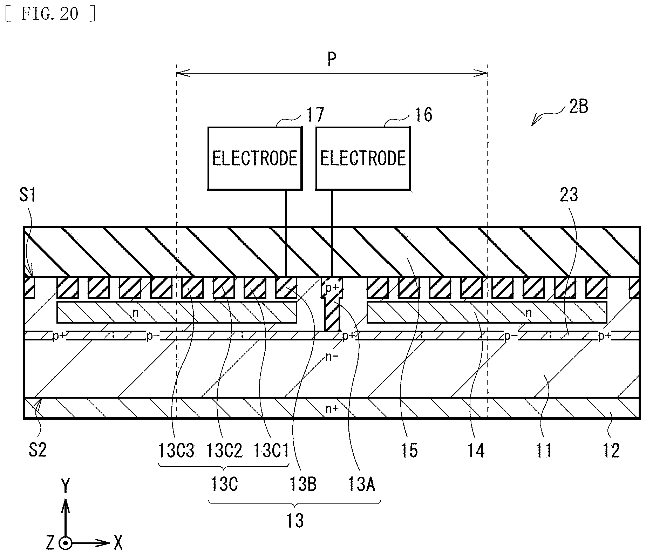

FIG. 20 schematically illustrates an example of a cross-sectional configuration of a light-receiving element (a light-receiving element 2B) according to Modification Example 8 of the present disclosure. The barrier layer 23 extending across the entire unit pixel P may further include a p-type impurity region having a different impurity concentration in a plane. Specifically, a p-type semiconductor region having an impurity concentration higher than another region may be formed around a coupling part with the anode 13A and a periphery thereof. This facilitates formation of an electric field in the horizontal direction (e.g., X-Y plane direction) in addition to the effects of the foregoing second embodiment, thus making it possible to improve transfer efficiency of signal charge (holes) to the anode 13A.

### <5. Third Embodiment>

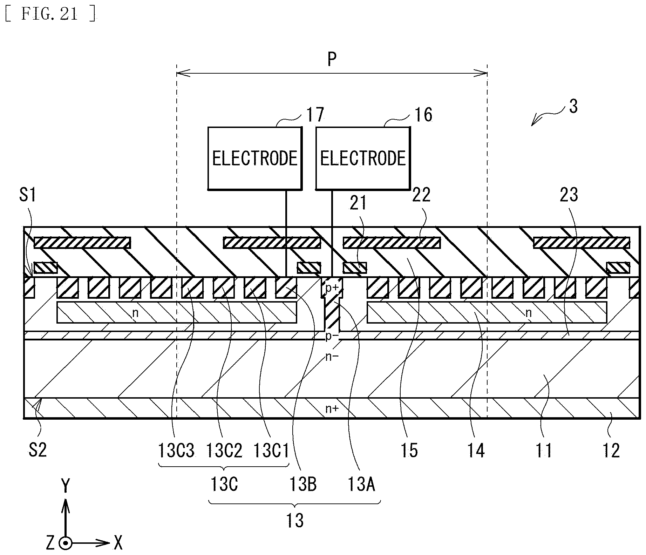

FIG. 21 schematically illustrates an example of a cross-sectional configuration of a light-receiving element (a light-receiving element 3) according to a third embodiment of the present disclosure. In the same manner as the foregoing first embodiment, the light-receiving element 3 includes, for example, a PIN type photodiode that applies a reverse bias between the front surface and the back surface of the semiconductor substrate 11. The light-receiving element 3 constitutes one pixel (unit pixel P) in an electromagnetic wave detector or a radiation imaging element (e.g., X-ray imaging element 100) to read information on a subject (to capture an image of a subject) on the basis of a radioactive ray (e.g., α-ray, β-ray, γ-ray, and X-ray, etc.).

The light-receiving element 3 of the present embodiment is a combination of the technology of the foregoing first embodiment and the technology of the foregoing second embodiment. That is, the light-receiving element 3 includes: the gate electrode 21 and the wiring layer 22, which are provided in the insulating layer 15 between the anode 13A and the drain 13B and applies an electric field to the interface of the front surface S1 of the semiconductor substrate 11 between the anode 13A and the drain 13B or reduces the volume of the insulating layer 15 provided on the semiconductor substrate 11 between the anode 13A and the drain 13B; and the barrier layer 23 facing the embedded layer 14 provided inside the semiconductor substrate 11 on the side opposite to the side of the p-type electrically-conductive region 13.

This makes it possible, in the light-receiving element 3 of the present embodiment, to improve the transfer efficiency of signal charge (holes) generated in the semiconductor substrate 11 while improving the resistance to the fluctuations in a capacity and an electric field due to X-ray irradiation.

### <6. Application Example>

FIG. 22 illustrates a functional configuration of the X-ray imaging element 100 as an example of an electronic apparatus using the light-receiving element (e.g., light-receiving element 1) described in the foregoing first to third embodiments and Modification Examples 1 to 8. The X-ray imaging element 100 reads information on a subject (captures an image of a subject) on the basis of an incident radioactive ray Rrad (e.g., α-ray, β-ray, γ-ray, and X-ray, etc.), for example. The X-ray imaging element 100 includes a pixel section (pixel region 1 10A), and includes, as a drive circuit (peripheral circuit section) of the pixel region 110A, a row scanning section 121, an A/D conversion section 122, a column scanning section 123, and a system control section 124.

### (Pixel Region 110A)

The pixel region 110A includes a plurality of unit pixels (imaging pixels) P that generates signal charge on the basis of a radioactive ray. The plurality of unit pixels P are two-dimensionally arranged in matrix (in a matrix shape). It is to be noted that, as illustrated in FIG. 1, a horizontal direction (row direction) in the pixel region 110A is defined as an "H" direction, and a vertical direction (column direction) is defined as a "V" direction.

### (Row Scanning Section 121)

The row scanning section 121 includes a later-described shift register circuit, a predetermined logic circuit, and the like, and is a pixel drive section (row scanning circuit) that performs driving (line-sequential scanning), on a row-by-row basis (in unit of horizontal lines), on the plurality of unit pixels Pin the pixel region 110A. Specifically, the row scanning section 121 performs an imaging operation such as a read operation or a reset operation on each of the unit pixels P by line-sequential scanning, for example. It is to be noted that the line-sequential scanning is performed by supplying each of the unit pixels P with a row scanning signal described above via a readout control line Lread.

### (A/D Conversion Section 122)

The A/D conversion section 122 includes a plurality of column selection sections 125 each provided for every plurality of (four, in this example) signal lines Lsig, and performs A/D conversion (analog/digital conversion) on the basis of a signal voltage (voltage in response to signal charge) inputted via the signal line Lsig. This allows output data Dout (imaging signal) including a digital signal to be generated and outputted to the outside.

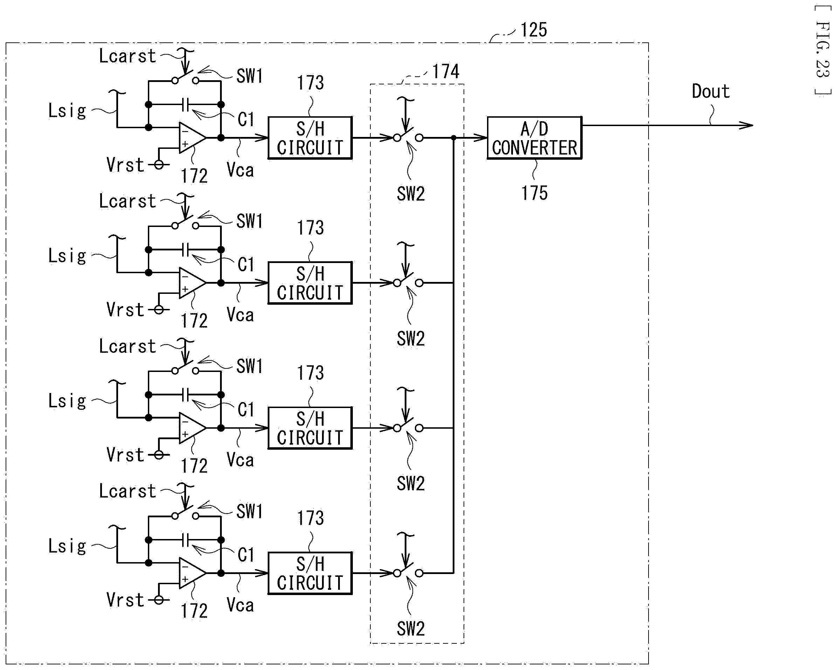

For example, as illustrated in FIG. 23, each of the column selection sections 125 includes a charge amplifier 172, a capacitor (condenser or feedback capacitor, etc.) C1, a switch SW1, a sample-and-hold (S/H) circuit 173, a multiplexer circuit (selection circuit) 174 including four switches SW2, and an A/D converter 175. Of these, the charge amplifier 172, the capacitor C1, the switch SW1, the S/H circuit 173, and the switch SW2 are provided for each of the signal lines Lsig. The multiplexer circuit 174 and the A/D converter 175 are provided for each of the column selection sections 125. It is to be noted that the charge amplifier 172, the capacitor C1, and the switch SW1 constitute a charge amplifier circuit.

The charge amplifier 172 is an amplifier (amplifier) to perform conversion (Q-V conversion) of signal charge read from the signal line Lsig. In the charge amplifier 172, one end of the signal line Lsig is coupled to an input terminal on a negative side (- side), and a predetermined reset voltage Vrst is inputted to an input terminal on a positive side (+ side). An output terminal and the input terminal on the negative of the charge amplifier 172 are feedback-coupled to each other (feedback coupling) via a parallel connection circuit of the capacitor C1 and the switch SW1. That is, one terminal of the capacitor C1 is coupled to the input terminal on the negative side of the charge amplifier 172, and another terminal thereof is coupled to the output terminal of the charge amplifier 172. Likewise, one terminal of the switch SW1 is coupled to the input terminal on the negative side of the charge amplifier 172, and another terminal thereof is coupled to the output terminal of the charge amplifier 172. It is to be noted that an ON/OFF state of the switch SW1 is controlled by a control signal (amplifier reset control signal) supplied from the system control section 124 via an amplifier reset control line Lcarst.

The S/H circuit 173 is disposed between the charge amplifier 172 and the multiplexer circuit 174 (switch SW2), and is a circuit to temporarily hold an output voltage Vca from the charge amplifier 172.

The multiplexer circuit 174 is a circuit that selectively couples or decouples each of the S/H circuits 173 and the A/D converter 175 to and from each other by sequentially bringing one of the four switches SW2 into an ON state in accordance with scan driving by the column scanning section 123.

The A/D converter 175 is a circuit that generates and outputs the above-described output data Dout by performing A/D conversion on an output voltage from the S/H circuit 173 inputted via the switch SW2.

### (Column Scanning Section 123)

The column scanning section 123 includes, for example, an unillustrated shift register, address decoder, and the like, and drives the switches SW2 in sequence in the above-described column selection section 125 while scanning. Such selective scanning by the column scanning section 123 allows signals (output data Dout described above) of the respective unit pixels P read via the respective signal lines Lsig to be outputted in sequence to the outside.

### (System Control Section 124)

The system control section 124 controls respective operations of the row scanning section 121, the A/D conversion section 122, and the column scanning section 123. Specifically, the system control section 124 includes a timing generator that generates various timing signals (control signals) described above, and performs drive control of the row scanning section 121, the A/D conversion section 122, and the column scanning section 123 on the basis of the various timing signals generated by the timing generator. On the basis of the control of the system control section 124, the row scanning section 121, the A/D conversion section 122, and the column scanning section 123 each perform imaging driving (line-sequential imaging driving) on the plurality of unit pixels P in the pixel region 110A, thereby allowing the output data Dout to be acquired from the pixel region 110A.

Although the description has been given above by referring to the first to third embodiments, Modification Examples 1 to 8, and the application example, the contents of the present disclosure are not limited to the foregoing embodiments, and the like, and may be modified in a wide variety of ways. For example, the foregoing embodiment, and the like exemplify the use of holes as signal charge; however, electrons may be used as the signal charge. It is to be noted, in that case, each member has an electrically-conductive type which is the opposite electrically-conductive type.

In addition, the layer configuration of the light-receiving element 1 described in the foregoing embodiments, and the like is merely exemplary, and another layer may further be included. Further, the materials or the thicknesses of the respective layers are also exemplary, and are not limited to those described above. Furthermore, although the foregoing application example mentions the X-ray imaging element 100, the light-receiving element 1 described in the foregoing embodiment, and the like is also applicable to a radiation imaging element or an electromagnetic wave detector of which application is not limited to an X-ray.

It is to be noted that the effects described herein are merely exemplary and non-limiting, and may have other effects.

It is to be noted that the present disclosure may also have the following configurations. According to the present technology of the following configurations, a first first electrically-conductive region coupled to a first electrode and a second first electrically-conductive region coupled to a second electrode are provided at an interface of a first surface of a semiconductor substrate including a photoelectric conversion region, and an electrically-conductive film applying an electric field to the interface of the first surface is provided above the first surface of the semiconductor substrate at least between the first first electrically-conductive region and the second first electrically-conductive region. This suppresses generation of fixed electric charge and generation of an interface state near the interface of the first surface. It is therefore possible to improve resistance to fluctuations in a capacity and an electric field due to X-ray irradiation. In addition, it is possible to reduce generation of a dark current.
(1) A light-receiving element including:
   a semiconductor substrate including a photoelectric conversion region;
   a first first electrically-conductive region provided at an interface of a first surface of the semiconductor substrate and coupled to a first electrode;
   a second first electrically-conductive region provided at the interface of the first surface and around the first first electrically-conductive region and coupled to a second electrode;
   a third first electrically-conductive region provided at the interface of the first surface and around the second first electrically-conductive region and being in an electrically floating state; and
   an electrically-conductive film provided above the first surface at least between the first first electrically-conductive region and the second first electrically-conductive region.
(2) The light-receiving element according to (1), in which the electrically-conductive film applies an electric field to the interface of the first surface between the first first electrically-conductive region and the second first electrically-conductive region.
(3) The light-receiving element according to (1) or (2), further including an insulating layer provided on a side of the first surface of the semiconductor substrate, in which
   the electrically-conductive film is formed by at least one of a gate electrode provided on the first surface of the semiconductor substrate or a wiring layer provided in the insulating layer.
(4) The light-receiving element according to (3), in which the gate electrode and the wiring layer are electrically coupled to each other.
(5) The light-receiving element according to (3), in which the gate electrode, the wiring layer, and the second first electrically-conductive region are electrically coupled to one another.
(6) The light-receiving element according to any one of (3) to (5), in which the wiring layer is formed continuously or intermittently from between the first first electrically-conductive region and the second first electrically-conductive region to above the third first electrically-conductive region.
(7) The light-receiving element according to any one of (3) to (6), in which the gate electrode is formed using a semiconductor material and includes a first region and a second region having different impurity concentrations.
(8) The light-receiving element according to (7), in which the first region has an impurity concentration lower than the second region and is provided near the first first electrically-conductive region.
(9) The light-receiving element according to (7), in which the first region has an impurity concentration lower than the second region and is provided around the second region.
(10) The light-receiving element according to (7), in which the first region has an impurity concentration lower than the second region and is stacked in an order of the first region and the second region from the side of the first surface.
(11) The light-receiving element according to any one of (1) to (10), further including a second electrically-conductive region embedded and formed in the semiconductor substrate and facing the second first electrically-conductive region and the third first electrically-conductive region.
(12) The light-receiving element according to (11), further including a fourth first electrically-conductive region embedded and formed in the semiconductor substrate and facing the second electrically-conductive region on a side of a second surface opposed to the first surface of the semiconductor substrate.
(13) The light-receiving element according to (12), in which the fourth first electrically-conductive region extends to below the first first electrically-conductive region and is coupled to the first first electrically-conductive region.
(14) The light-receiving element according to (13), in which the fourth first electrically-conductive region includes regions of different impurity concentrations.
(15) The light-receiving element according to any one of (11) to (14), in which
   the semiconductor substrate further includes a second electrically-conductive layer having a second electrically-conductive type and being provided at an interface of a second surface opposed to the first surface, and
   the second electrically-conductive layer and the second electrically-conductive region each have an impurity concentration higher than the semiconductor substrate.
(16) The light-receiving element according to any one of (1) to (15), in which the semiconductor substrate is configured by an intrinsic semiconductor.
(17) An X-ray imaging element including a plurality of light-receiving elements generating signal charge based on an X-ray,
   the light-receiving elements each including
   a semiconductor substrate including a photoelectric conversion region,
   a first first electrically-conductive region provided at an interface of a first surface of the semiconductor substrate and coupled to a first electrode,
   a second first electrically-conductive region provided at the interface of the first surface and around the first first electrically-conductive region and coupled to a second electrode,
   a third first electrically-conductive region provided at the interface of the first surface and around the second first electrically-conductive region and being in an electrically floating state, and
   an electrically-conductive film provided above the first surface at least between the first first electrically-conductive region and the second first electrically-conductive region.
(18) The X-ray imaging element according to (17), including
   a pixel region in which a plurality of pixels are arranged; and
   a peripheral region provided around the pixel region, in which
   the semiconductor substrate includes a depletion region in the pixel region and includes a neutral region in the peripheral region.
(19) The X-ray imaging element according to (18), in which
   the light-receiving elements are provided for the respective pixels, and
   the light-receiving element includes a p-n junction light-receiving element that applies a reverse bias between the first surface of the semiconductor substrate and a second surface opposed to the first surface.
(20) An electronic apparatus including an X-ray imaging element,
   the X-ray imaging element including a plurality of light-receiving elements generating signal charge based on an X-ray,
   the light-receiving elements each including
      a semiconductor substrate including a photoelectric conversion region,
      a first first electrically-conductive region provided at an interface of a first surface of the semiconductor substrate and coupled to a first electrode,
      a second first electrically-conductive region provided at the interface of the first surface and around the first first electrically-conductive region and coupled to a second electrode,
      a third first electrically-conductive region provided at the interface of the first surface and around the second first electrically-conductive region and being in an electrically floating state, and
      an electrically-conductive film provided above the first surface at least between the first first electrically-conductive region and the second first electrically-conductive region.
(21) A light-receiving element including:
   a semiconductor substrate including a photoelectric conversion region;
   a first first electrically-conductive region provided at an interface of a first surface of the semiconductor substrate and coupled to a first electrode;
   a second first electrically-conductive region provided at the interface of the first surface and around the first first electrically-conductive region and coupled to a second electrode;
   a third first electrically-conductive region provided at the interface of the first surface and around the second first electrically-conductive region and being in an electrically floating state;
   a second electrically-conductive region embedded and formed in the semiconductor substrate and facing the second first electrically-conductive region and the third first electrically-conductive region; and
   a fourth first electrically-conductive region embedded and formed in the semiconductor substrate and facing the second electrically-conductive region on a side of a second surface opposed to the first surface of the semiconductor substrate.
(22) The light-receiving element according to (21), in which
   the fourth first electrically-conductive region extends to below the first first electrically-conductive region, and
   the first first electrically-conductive region and the fourth first electrically-conductive region are electrically coupled to each other.
(23) The light-receiving element according to (21) or (22), in which the fourth first electrically-conductive region includes regions of different impurity concentrations.

This application claims the benefit of Japanese Priority Patent Application JP2021-075731 filed with the Japan Patent Office on April 28, 2021, the entire contents of which are incorporated herein by reference.

It should be understood by those skilled in the art that various modifications, combinations, sub-combinations, and alterations may occur depending on design requirements and other factors insofar as they are within the scope of the appended claims or the equivalents thereof.

## Claims

1. A light-receiving element comprising:
a semiconductor substrate including a photoelectric conversion region;
a first first electrically-conductive region provided at an interface of a first surface of the semiconductor substrate and coupled to a first electrode;
a second first electrically-conductive region provided at the interface of the first surface and around the first first electrically-conductive region and coupled to a second electrode;
a third first electrically-conductive region provided at the interface of the first surface and around the second first electrically-conductive region and being in an electrically floating state; and
an electrically-conductive film provided above the first surface at least between the first first electrically-conductive region and the second first electrically-conductive region.

2. The light-receiving element according to claim 1, wherein the electrically-conductive film applies an electric field to the interface of the first surface between the first first electrically-conductive region and the second first electrically-conductive region.

3. The light-receiving element according to claim 1, further comprising an insulating layer provided on a side of the first surface of the semiconductor substrate, wherein
the electrically-conductive film is formed by at least one of a gate electrode provided on the first surface of the semiconductor substrate or a wiring layer provided in the insulating layer.

4. The light-receiving element according to claim 3, wherein the gate electrode and the wiring layer are electrically coupled to each other.

5. The light-receiving element according to claim 3, wherein the gate electrode, the wiring layer, and the second first electrically-conductive region are electrically coupled to one another.

6. The light-receiving element according to claim 3, wherein the wiring layer is formed continuously or intermittently from between the first first electrically-conductive region and the second first electrically-conductive region to above the third first electrically-conductive region.

7. The light-receiving element according to claim 3, wherein the gate electrode is formed using a semiconductor material and includes a first region and a second region having different impurity concentrations.

8. The light-receiving element according to claim 7, wherein the first region has an impurity concentration lower than the second region and is provided near the first first electrically-conductive region.

9. The light-receiving element according to claim 7, wherein the first region has an impurity concentration lower than the second region and is provided around the second region.

10. The light-receiving element according to claim 7, wherein the first region has an impurity concentration lower than the second region and is stacked in an order of the first region and the second region from the side of the first surface.

11. The light-receiving element according to claim 1, further comprising a second electrically-conductive region embedded and formed in the semiconductor substrate and facing the second first electrically-conductive region and the third first electrically-conductive region.

12. The light-receiving element according to claim 11, further comprising a fourth first electrically-conductive region embedded and formed in the semiconductor substrate and facing the second electrically-conductive region on a side of a second surface opposed to the first surface of the semiconductor substrate.

13. The light-receiving element according to claim 12, wherein the fourth first electrically-conductive region extends to below the first first electrically-conductive region and is coupled to the first first electrically-conductive region.

14. The light-receiving element according to claim 13, wherein the fourth first electrically-conductive region includes regions of different impurity concentrations.

15. The light-receiving element according to claim 11, wherein
the semiconductor substrate further includes a second electrically-conductive layer having a second electrically-conductive type and being provided at an interface of a second surface opposed to the first surface, and
the second electrically-conductive layer and the second electrically-conductive region each have an impurity concentration higher than the semiconductor substrate.

16. The light-receiving element according to claim 1, wherein the semiconductor substrate is configured by an intrinsic semiconductor.

17. An X-ray imaging element comprising a plurality of light-receiving elements generating signal charge based on an X-ray,
the light-receiving elements each including
a semiconductor substrate including a photoelectric conversion region,
a first first electrically-conductive region provided at an interface of a first surface of the semiconductor substrate and coupled to a first electrode,
a second first electrically-conductive region provided at the interface of the first surface and around the first first electrically-conductive region and coupled to a second electrode,
a third first electrically-conductive region provided at the interface of the first surface and around the second first electrically-conductive region and being in an electrically floating state, and
an electrically-conductive film provided above the first surface at least between the first first electrically-conductive region and the second first electrically-conductive region.

18. The X-ray imaging element according to claim 17, comprising
a pixel region in which a plurality of pixels are arranged; and
a peripheral region provided around the pixel region, wherein
the semiconductor substrate includes a depletion region in the pixel region and includes a neutral region in the peripheral region.

19. The X-ray imaging element according to claim 18, wherein
the light-receiving elements are provided for the respective pixels, and
the light-receiving element comprises a p-n junction light-receiving element that applies a reverse bias between the first surface of the semiconductor substrate and a second surface opposed to the first surface.

20. An electronic apparatus comprising an X-ray imaging element,
the X-ray imaging element including a plurality of light-receiving elements generating signal charge based on an X-ray,
the light-receiving elements each including
a semiconductor substrate including a photoelectric conversion region,
a first first electrically-conductive region provided at an interface of a first surface of the semiconductor substrate and coupled to a first electrode,
a second first electrically-conductive region provided at the interface of the first surface and around the first first electrically-conductive region and coupled to a second electrode,
a third first electrically-conductive region provided at the interface of the first surface and around the second first electrically-conductive region and being in an electrically floating state, and
an electrically-conductive film provided above the first surface at least between the first first electrically-conductive region and the second first electrically-conductive region.
